# FASCICULE DE BREVET EUROPEEN

(11) **EP 0 578 551 B1**
(45) Date de publication et mention de la délivrance du brevet: **01.10.1997**
(21) Numéro de dépôt: 93401732.8
(22) Date de dépôt: 05.07.1993
(51) Int. Cl.: B41F 15/22, B65H 29/08, B41F 15/14

(54) **Perfectionnements aux machines d'impression, notamment aux machines de sérigraphie**
Verbesserungen in Druckmaschinen, insbesondere für Sieb- druckmaschinen
Improvements in printing machines, especially for screen printers

(30) Priorité: 07.07.1992 FR 9208351
(43) Date de publication de la demande: 12.01.1994
(73) Titulaire: SILIUM Société française à responsabilité limitée, F-75018 Paris (FR)
(72) Inventeur: David, Bernard, F-93170 Bagnolet (FR)
(74) Mandataire: Orès, Bernard

(56) Documents cités:
- EP-A- 0 074 600
- EP-A- 0 177 391
- EP-A- 0 202 740
- EP-A- 0 453 988
- DE-A- 2 256 815
- GB-A- 2 019 319
- US-A- 4 031 824
- US-A- 4 058 307

## Description

L'invention concerne des perfectionnements aux machines d'impression, notamment aux machines de sérigraphie.

On sait que de telles machines, dites encore "d'impression à l'écran de soie", comprennent principalement un écran derrière lequel est amené, puis maintenu en position par un marbre d'impression, l'objet à imprimer, par exemple une feuille de papier. Pour que soit obtenue une bonne qualité d'impression, en particulier dans le cas de sujet à plusieurs couleurs, il importe que les réglages préalables de la machine puissent être réalisés aisément, ce qui exige une bonne accessibilité des trois principaux éléments de la machine, à savoir le marbre d'impression qui se trouve derrière l'écran, l'écran lui-même et le dispositif de nappage et de réglage d'encre qui se trouve devant l'écran. On a ainsi proposé, pour satisfaire à cette condition d'accessibilité, des machines où les trois éléments sont disposés horizontalement les uns au-dessous des autres (voir GB-A-2 019 319) où le marbre d'impression est guidé dans son déplacement par des montants disposés en ses angles, ou encore des machines dans lesquelles le plateau d'impression est en porte-à-faux, monté à pivotement sur un bâti, comme décrit dans EP-0 177 391. Si une machine selon ce Brevet Européen donne satisfaction, en ce qui concerne l'impression proprement dite, elle a pour inconvénient que le transfert d'une feuille imprimée du marbre d'impression vers le tunnel de séchage est rendu difficile par le fait que ce dernier comprend un tapis sans fin dont le brin opératoire est horizontal, tandis que le marbre d'impression est incliné sur l'horizontale à la fin d'un cycle d'impression.

En outre, étant donné que dans les machines connues le transfert de l'objet imprimé entre le marbre d'impression et le tunnel de séchage s'effectue à l'aide de ventouses à dépression, la partie de l'objet avec laquelle coopèrent lesdites ventouses et dont la largeur peut être de l'ordre de quelques centimètres est inutilisable. Comme l'on cherche à réduire cette marge inutilisée de l'objet imprimé, -que celui-ci soit une feuille de papier, un support de circuits imprimés, etc...-, d'une part, et que, d'autre part, l'on cherche à faciliter le passage dudit objet du marbre d'impression vers le tunnel de séchage (indispensable dans l'impression par sérigraphie qui fait appel à une couche d'encre épaisse) on a proposé, par exemple dans US-A-4 031 824, une machine d'impression équipée d'une pince unique règnant sur toute la largeur de la machine. Un tel dispositif à commande par came n'est pas suffisamment souple d'utilisation pour règler les problèmes posés par les machines connues utilisant des ventouses à dépression.

Une machine d'impression correspondant au préambule de la revendication 1 est connue du Brevet des Etats-Unis US-4 058 307.

Les Demandes de Brevet Européen EP-A-453 988 et EP-A-74 600 concernent des machines d'impression équipées de dispositifs de reprise présentant une multiplicité de pinces individuelles.

C'est, d'une façon générale, un but de l'invention de fournir des perfectionnements aux machines d'impression, notamment de sérigraphie, qui pallient ces inconvénients.

C'est, encore, un but de l'invention de fournir des perfectionnements aux machines d'impression et notamment de sérigraphie qui permettent de diminuer la marge non utilisée de l'objet imprimé.

C'est, aussi, un but de l'invention de fournir de tels perfectionnements, en particulier un dispositif de reprise des objets imprimés pour leur transfert du marbre d'impression vers un tunnel de séchage qui soit d'un fonctionnement sûr et, partant delà, permette de tenir les cadences de production élevées qui sont celles recherchées par l'industrie graphique.

Ces buts et d'autres encore sont atteints dans une machine d'impression, plus particulièrement de sérigraphie, par un dispositif de reprise d'objets plats comme des feuilles de papier, des feuilles de circuits imprimés ou analogues pour leur transfert d'un premier support à un second support à l'aide de moyens de préhension mobiles du type "pinces" tel que défini dans la revendication 1. Des modes de réalisation avantageux sont donnés dans les revendications 2 à 10.

Le dispositif de commande est avantageusement un vérin à double effet dont la tige est attelée sur le bec par l'intermédiaire d'une chape de position réglable par rapport à la tige de vérin.

Selon une autre caractéristique de l'invention, chaque "pince" comprend un ressort de rappel attaché, d'une part, sur une biellette et, d'autre part, sur un montant qui porte aussi la biellette qui est également articulée sur ledit bec.

Dans une réalisation préférée de l'invention, les montants de la multiplicité de "pinces" individuelles sont fixés sur une même cornière pivotant autour de l'axe disposé sous les supports.

Lesdits supports présentent des encoches disposées en regard et dans lesquelles peuvent pénétrer, en partie au moins, les "pinces".

L'invention a aussi pour objet une machine d'impression, notamment de sérigraphie, comportant un dispositif de reprise tel que défini ci-dessus.

L'invention sera bien comprise par la description qui suit, faite à titre d'exemple et en référence au dessin annexé dans lequel :
- la figure 1 représente schématiquement et de profil le marbre d'impression, le plateau support et les moyens d'équilibrage et de commande dudit plateau d'une machine selon l'invention ;
- la figure 2 est une vue en perspective d'un dispositif de "pinces" pour la reprise des objets imprimés sur le marbre d'impression ;
- la figure 3 est une vue schématique partielle d'une plaquette de guidage d'un transporteur ;
- la figure 4 est une vue en coupe, à plus grande échelle, d'une des "pinces" du dispositif montré sur la figure 2.

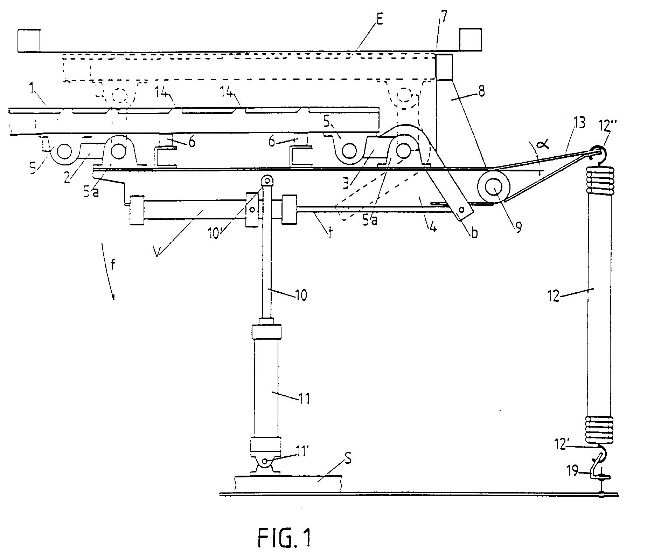

Une machine d'impression, notamment de sérigraphie selon l'invention est montrée schématiquement sur la figure 1. Elle comprend un écran d'impression, E, horizontal et fixe en condition de travail, disposé au-dessus d'un plateau 4, avec interposition entre ledit plateau et l'écran d'un marbre d'impression 1. Le plateau 4, disposé horizontalement en condition de fonctionnement normal de la machine, est monté à pivotement autour d'un axe horizontal 9, à l'arrière de la machine par rapport à l'utilisateur qui se tient, quant à lui, à l'avant de la machine, c'est-à-dire sur la partie gauche du dessin de la figure 1. Sous le plateau 4 est disposé un vérin 11 dont une extrémité 11' est attelée sur le socle S de la machine et dont la tige 10 s'attache à son extrémité 10' sensiblement au milieu du plateau 4. Sur le socle S est également accrochée en 19 l'extrémité 12' d'un ressort 12 dont l'autre extrémité 12'' est accrochée sur une partie 13 prolongeant le plateau 4 au-delà de l'axe 9 et qui forme ainsi un bras de levier incliné d'un angle α sur l'horizontale. L'angle α est choisi pour que, lors de la rétraction de la tige 10 du vérin 11, la diminution de la longueur efficace du bras de levier 13 compense l'action qu'exerce les ressorts 12, une telle disposition permettant de choisir un vérin 11 de faible puissance, d'une part, et d'éviter un pivotement intempestif du plateau, en cas de défaillance dudit vérin, d'autre part.

Dans la forme de réalisation décrite et représentée, un angle α d'environ 11° s'est révélé satisfaisant pour assurer l'équilibre du plateau 4, du marbre 1 et des accessoires de la machine, même en cas de rupture d'alimentation du vérin 11, lequel est rendu opératoire, pour faire pivoter le plateau 4 dans le sens de la flèche f lorsque, comme requis sur toute machine d'impression et notamment de sérigraphie, on souhaite accéder sous l'écran d'impression E.

Selon une autre caractéristique de l'invention, le marbre d'impression 1 est monté sur le plateau 4 par un système de parallélogrammes articulés comprenant des biellettes 2 et 3 disposées au voisinage des angles du marbre 1 et qui tourillonnent à leurs extrémités sur des paliers 5 fixés sur la face inférieure du marbre 1 et 5a fixés sur la face de dessus du plateau 4. Ce dernier porte aussi des butées 6, qui limitent le mouvement de descente du marbre 1 et, sur un support 8, une butée élastique 7, de surface relativement importante, prévue pour limiter le débattement en position haute du marbre 1 afin d'assurer un positionnement précis de celui-ci par rapport à l'écran E. Le mouvement du marbre 1, entre la position montrée en trait plein sur la figure 1, -et qui est celle en laquelle il reçoit un objet à imprimer-, et celle montrée en traits pointillés, -qui est celle d'impression dudit objet-, est de préférence commandé par un vérin V dont la tige t est attelée à l'extrémité d'un bras b pivotant autour des paliers 5a prévus à l'arrière du plateau 4 et relié aux biellettes 3.

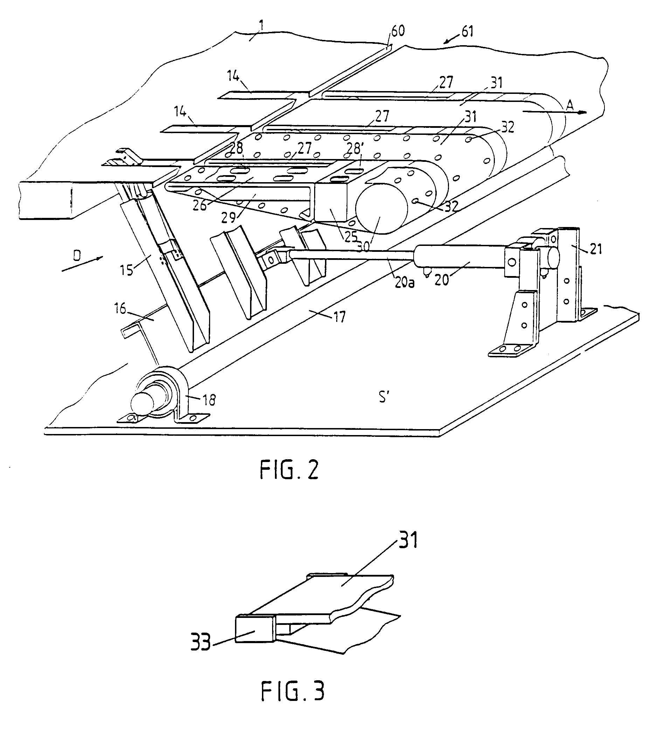

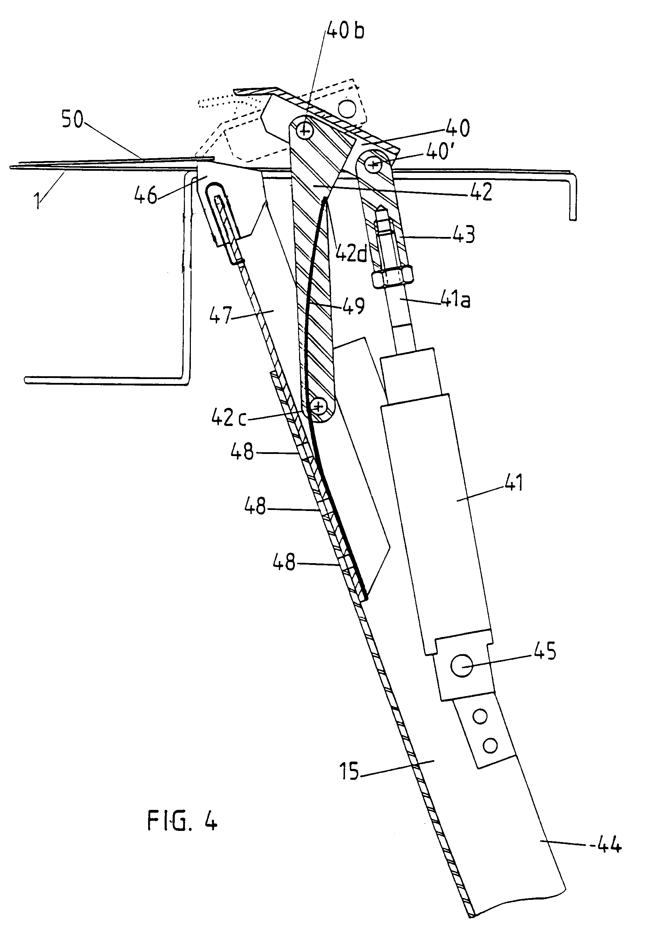

Pour la reprise des objets disposés sur le marbre 1, après l'opération d'impression, ledit marbre comporte sur son bord 60, figure 2, adjacent à un transporteur 61 qui sera décrit plus en détail ci-après, des encoches 14 dans lesquelles peuvent pénétrer les pinces de préhension 15 d'un dispositif D de reprise, pinces qui sont disposées parallèlement les unes aux autres et en nombre correspondant aux dimensions des objets à transférer entre le marbre et le transporteur 61. Chaque pince 15, figure 4, comporte un montant à section droite en U, 44, fixé à sa partie inférieure sur une cornière 16, elle-même montée à pivotement autour d'un axe 17 tourillonnant dans deux paliers à billes 18 fixés sur le socle S' et, sur le support 44 :
. un vérin pneumatique 41 articulé sur le montant 44 par un axe 45 ;
. une chape 43 réglable en hauteur et solidaire de la tige 41a du vérin 41 ;
. une pièce 40 formant bec supérieur, articulée autour d'un axe 40' sur la chape 43 ;
. une biellette 42 articulée à sa partie inférieure autour d'un axe 42c et à sa partie supérieure autour d'un axe 40b sur le bec 40 ;
. une partie 46 formant enclume pour ménager avec le bec 40 une "pince", ladite partie étant en un matériau élastique et étant rapportée sur un porte-enclume 47 fixé par des rivets 48 sur le montant 44 ; et
. un fil flexible 49 en "épingle à cheveux" dont l'extrémité supérieure prend appui dans l'encoche 42d de la biellette 42, le centre est retenu sous l'axe 42c, et l'autre extrémité s'appuie dans le fond du montant 44.

La commande du dispositif D de pinces 15 est effectuée à l'aide d'un vérin 20, figure 2, articulé par son corps sur un support 21 reposant sur le socle S' et dont la tige 20a est attelée en partie haute de la cornière 16, la disposition étant telle que lorsque la tige 20a du vérin 20 est dans sa position sortie les pinces 15 alors logées dans les encoches 14 peuvent assurer la reprise d'un objet imprimé reposant sur le marbre 1, par exemple une feuille 50, figure 4. Lorsque la tige 20a du vérin 20 est, par contre, en condition rentrée, les pinces 15 sont dans la condition où le dispositif D peut déposer la feuille 50 sur le transporteur 61 de transfert de la feuille vers le four de séchage.

Comme montré sur la figure 2, le transporteur 61 est constitué par une poutre 25, sensiblement horizontale, sur laquelle est fixée une plaque 26 dirigée vers le marbre 1 et qui comporte des encoches 27 en même nombre que les encoches 14 dudit marbre, en regard de ces dernières. Dans la plaque 26 sont ménagées des perforations 28 sous lesquelles règnent de petits caissons 29 qui communiquent avec la poutre 25 dont la face supérieure présente, en outre, des perforations 28' alignées avec les perforations 28 de la plaque 26. La poutre 25, qui est reliée à une source de dépression, non représentée, porte également sur une de ses faces opposée à celle portant la plaque 26 un rouleau caoutchouté 30 (entraîné en rotation par un moto-variateur, non représenté) et sur lequel s'enroulent des courroies 31 dont la largeur est celle séparant deux encoches 27 et qui sont percées de trous 32 alignés avec les perforations 28 et 28' de la plaque 26, d'une part, et de la poutre 25, d'autre part, le guidage latéral desdites courroies étant assuré par des plaquettes 33, figure 3.

Le fonctionnement d'un dispositif et d'une machine selon l'invention est le suivant :

Dans la position basse du marbre 1, montrée en trait plein, figure 1, les pinces 15 sont en position arrière, c'est-à-dire celle qui correspond à la position rentrée de la tige 20a du vérin 20 : une feuille 50 à imprimer est positionnée contre des cales, non représentées, sur le marbre 1. Celui-ci est alors soulevé, par actionnement du verin V, jusqu'à prendre la position montrée en traits pointillés sur la figure 1 : le processus d'impression se déroule et, lorsqu'il est terminé, le marbre 1 est ramené à sa position initiale. Au cours du processus d'impression, l'actionnement du vérin 20 provoque la sortie de la tige 20a et l'amenée des pinces 15 dans la position "avant" et, plus précisément, celle montrée en trait plein sur la figure 4 où les pinces sont logées dans les encoches 14, avec leur bec supérieur 40 dans la condition montrée en trait plein sur la figure 4, à savoir distante des enclumes 46.

Lorsque la feuille 50 imprimée est posée sur les enclumes 46, -dont la distance par rapport à la position haute des becs 40 est réglée par la chape 43 de manière à permettre juste le passage d'une feuille 50-, on commande les vérins 41 à double effet de manière à faire sortir leur tige 41a. En raison de ce mouvement, d'une part, et de l'action de la biellette 42, d'autre part, le bec supérieur 40 prend d'abord la position montrée en pointillés, -et qui correspond à une avancée horizontale de l'ordre d'une dizaine de mm de la pointe du bec-, puis poursuit son déplacement jusqu'à atteindre la position montrée en tirets qui est celle de fermeture de la pince et de serrage entre l'enclume 46 et le bec supérieur de la feuille 50. Au cours du mouvement qui fait passer le bec supérieur 40 de la position en traits pointillés à celle en tirets, et qui correspond par exemple à un déplacement vertical de la pointe du bec d'environ 15 mm, la biellette 42 a pivoté autour de l'axe 42c tandis que le ressort 49 se détend. La feuille 50, saisie par une marge de faible largeur par exemple de l'ordre d'un demi cm, est alors transportée par une course de faible amplitude vers le transporteur 61 lorsque le vérin 20 est actionné pour faire rentrer sa tige 20a en vue de faire sortir les pinces 15 des encoches 14 pour les mettre en place dans les encoches 27.

Lorsque la feuille 50 est effectivement déposée sur le transporteur 61, et que les pinces 15 ont été réouvertes par un actionnement des vérins 41 inverse de celui décrit ci-dessus, -peu de temps avant la fin de leur mouvement vers l'arrière-, ladite feuille est aspirée contre les courroies 31 par la dépression transmise à partir de la poutre 25 dans les caissons 29, les perforations 28, 28' et 32, et elle est transportée dans le sens montré sur la flèche A, figure 2, vers le tunnel de séchage.

Après mise en place d'une nouvelle feuille 50 sur le marbre 1, c'est un même processus qui se déroule lorsque le dispositif D de pinces 15 a été à nouveau ramené vers l'avant.

## Revendications

1. Machine d'impression, notamment de sérigraphie, à écran (E) horizontal et fixe en condition de travail, placé au-dessus d'un premier support, à savoir un marbre d'impression (1) mobile pour amener au contact dudit écran un objet plat à imprimer (50), comme une feuille de papier, une feuille de circuits imprimés ou analogue, équipée d'un dispositif de reprise dudit objet (50) pour son transfert d'un premier support (1) à un second support, à savoir un dispositif de transport (61), à l'aide de moyens de préhension (15) mobiles, constitués par une multiplicité de pinces individuelles, chaque pince (15) comportant une enclume (46) et un bec (40) venant au contact de ladite enclume lorsqu'est rendu opératoire un dispositif de commande (41) caractérisée en ce que lesdites pinces sont montées à pivotement autour d'un axe (17) disposé au-dessous desdits supports (1,61), en ce que le premier et le deuxième support (1,61) présentent des encoches (14,27) disposées en regard et dans lesquelles peuvent pénétrer en partie au moins lesdites pinces (15), et en ce que ledit pivotement s'effectue une fois que ledit dispositif de commande a été rendu opératoire pour saisir l'objet plat disposé sur le premier support (1) , lesdites pinces (15) pénétrant successivement, lors dudit pivotement, dans les encoches (14) du premier support (1) puis dans les encoches (27) du deuxième support (61).

2. Machine d'impression selon la revendication 1, caractérisée en ce que le second support (61) comporte un moyen de dépression comprenant des perforations (28,28',32) et des courroies d'entraînement (31), lesdites perforations étant disposées de manière telle qu'après une ouverture des pinces (15) par action du dispositif de commande (41), intervenant avant la fin dudit mouvement de pivotement, l'objet plat est aspiré par dépression contre les courroies (31).

3. Machine d'impression, notamment de sérigraphie, selon une des revendications 1 ou 2, caractérisée en ce que ledit marbre d'impression (1) est monté sur un plateau (4) susceptible de pivoter autour d'un axe (9) au moyen de parallélogrammes articulés (2,3,5,5a).

4. Machine selon la revendication 3, caractérisée en ce que le plateau se prolonge au-delà de son axe de pivotement (9) par une partie formant levier (13) sur laquelle est attachée une des extrémités de ressorts (12) dont les autres extrémités sont fixées au socle (S) et en ce que le plateau (4) repose en outre au voisinage de son centre sur un vérin (11) de commande de pivotement dudit plateau autour de l'axe (9) de pivotement.

5. Machine selon une des revendications 3 à 4, caractérisée en ce que les parallélogrammes articulés sont constitués par des biellettes (2,3) articulées à leurs extrémités sur des chapes (5,5a) fixées, respectivement, sur le marbre d'impression (1) et sur le plateau (4).

6. Machine selon l'une quelconque des revendications 3 à 5, caractérisée en ce que le mouvement du marbre d'impression (1) est limité par des butées (6) fixées sur le plateau (4) en ce qui concerne la descente et par une butée élastique (7) de surface relativement importante solidaire d'un support (8) pour le positionnement précis, en position haute, du marbre d'impression (1) en réponse à l'actionnement d'un vérin de commande (V).

7. Machine selon une des revendications précédentes, caractérisée en ce que le dispositif de commande est un vérin (41) à double effet dont la tige (41a) est attelée sur le bec (40) par l'intermédiaire d'une chape (43) de position réglable par rapport à la tige du vérin.

8. Machine selon une des revendications précédentes, caractérisée en ce que chaque pince (15) comprend un fil flexible (49) en épingle à cheveux dont l'extrémité supérieure prend appui dans une encoche (42d) d'une biellette (42), dont le centre est retenu sous un axe (42c) de la biellette (42), et dont l'autre extrémité s'appuie dans un montant (44) qui porte aussi la biellette (42) également articulée sur ledit bec (40).

9. Machine selon la revendication 8, caractérisée en ce que les montants (44) de la multiplicité de pinces individuelles (15) sont fixés sur une même cornière (16) pivotant autour de l'axe (17) de pivotement des pinces (15).

10. Machine d'impression selon une des revendications précédentes, caractérisée en ce qu'elle comporte un vérin (20) de déplacement des pinces entre d'une part une position arrière, et d'autre part une position avant dans laquelle les pinces (15) sont logées dans les encoches (14) du premier support (1).

## Claims

1. A printing machine, in particular a silkscreen machine having a screen (E) that is horizontal and stationary in the working condition, placed above a first support, namely a moving printing slab (1) for bringing a flat object (50) such as a sheet of paper a sheet of printed circuits or the like into contact with said screen, the machine being fitted with a device for taking hold of said object (50) to transfer it from a first support (1) to a second support, namely a transporter device (61), with the help of moving grasping means (15) constituted by a multiplicity of individual clamps, each clamp (15) comprising an anvil (46) and a finger (40) coming into contact with said anvil when a control device (41) is operated, the machine being characterized in that said clamps are mounted to pivot about an axis (17) disposed beneath said supports (1, 61), in that the first and second supports (1, 61) have notches (14, 27) disposed facing one another and in which said clamps (15) can penetrate, at least in part, and in that said pivoting is performed once said control device has been operated to grasp the flat object disposed on the first support (1), said clamps (15) penetrating, during said pivoting, successively into the notches (14) of the first support (1) and then into the notches (27) of the second support (61).

2. A printing machine according to claim 1, characterized in that the second support (61) includes suction means comprising perforations (28, 28', 32) and drive belts (31), said perforations being disposed in such a manner that after the clamps (15) have been opened by action of the control device (41) taking place before the end of said pivoting movement, the flat object is held against the belts (31) by suction.

3. A printing machine, in particular a silkscreen machine, according to claim 1 or 2, characterized in that said printing slab (1) is mounted on a tray (4) capable of pivoting about an axis (9) by means of hinged parallelograms (2, 3, 5, 5a).

4. A machine according to claim 3, characterized in that the tray is extended beyond its pivot axis (9) by a lever-forming portion (13) to which springs (12) are attached via one of their ends while their other ends are fixed to the face (S), and in that the tray (4) also rests in the vicinity of its center on an actuator (11) for controlling pivoting of said tray about the pivot axis (9).

5. A machine according to claim 3 or 4, characterized in that the hinged parallelograms are constituted by links (2, 3) hinged at their ends to forks (5, 5a) fixed respectively to the printing slab (1) and to the tray (4).

6. A machine according to any one of claims 3 to 5, characterized in that the movement of the printing slab (1) is limited by stops (6) fixed on the tray (4) for downwards, and by a resilient stop (7) of relatively large area secured to a support (8) for accurately positioning the printing slab (1) when it is in its high position in response to a control actuator (V) being actuated.

7. A machine according to any preceding claim, characterized in that the control device is a double-acting cylinder (41) whose rod (41a) is coupled to the finger (40) via a fork (43) which is adjustable in position relative to the rod of the actuator.

8. A machine according to any preceding claim, characterized in that each clamp (15) includes a flexible hair-pin wire (49) whose top end bears in a notch (42d) of a link (42), whose center is held beneath a pin (42c) of the link (42), and whose other end bears against an upright (44) which also carries the link (42) that is also hinged to said finger (40).

9. A machine according to claim 8, characterized in that the uprights (44) of the multiplicity of individual clamps (15) are fixed to a common angle bar (16) that pivots about the pivot axis (17) of the clamps (15).

10. A printing machine according to any preceding claim, characterized in that it includes an actuator (20) for moving the clamps between a rear position and a front position in which the clamps (15) are received in the notches (14) of the first support (1).

## Patentansprüche

1. Druckmaschine, insbesondere für Siebdruck, mit einem im Betrieb horizontalen und feststehenden Schirm (E), der oberhalb einer ersten Auflage angeordnet ist, nämlich oberhalb eines beweglichen Druckfundaments (1), um einen zu bedruckenden flachen Gegenstand (50), wie z.B. ein Blatt Papier, eine Folie aus gedruckten Schaltungen oder dergleichen, mit dem Schirm in Kontakt zu bringen, ausgestattet mit einer Wiederaufnahmevorrichtung für den Gegenstand (50) für seine Überführung von einer ersten Auflage (1) zu einer zweiten Auflage, nämlich einer Transportvorrichtung (61), mit Hilfe von beweglichen Greifeinrichtungen (15), die aus einer Vielzahl einzelner Zangen bestehen, wobei jede Zange (15) einen Amboß (46) und eine Backe (40) aufweist, die mit dem Amboß in Berührung kommt, wenn eine Steuerungsvorrichtung (41) in Betrieb genommen wird, dadurch gekennzeichnet, daß die Zangen schwenkbar um eine Achse (17) gelagert sind, die unterhalb der Auflagen (1, 61) angeordnet ist, daß die erste und die zweite Auflage (1, 61) gegenüberliegend angeordnete Einschnitte (14, 27) aufweisen, in welche die Zangen (15) zumindest teilweise eindringen können, und daß das Schwenken einmal durchgeführt wird, wenn die Steuerungsvorrichtung in Betrieb genommen worden ist, um den auf der ersten Auflage (1) angeordneten flachen Gegenstand zu ergreifen, wobei die Zangen (15) während des Schwenkens in zunehmendem Maße in die Einschnitte (14) der ersten Auflage (1) und dann in die Einschnitte (27) der zweiten Auflage (61) eindringen.

2. Druckmaschine nach Anspruch 1, dadurch gekennzeichnet, daß die zweite Auflage (61) eine Unterdruckeinrichtung aufweist mit Perforierungen (28, 28', 32) und Antriebsriemen (31), wobei die Perforierungen so angeordnet sind, daß nach einem Öffnen der Zangen (15) durch Einwirkung der Steuerungsvorrichtung (41), das vor dem Ende der Schwenkbewegung stattfindet, der flache Gegenstand durch Unterdruck an die Riemen (31) angezogen wird.

3. Druckmaschine, insbesondere für Siebdruck, nach einem der Ansprüche 1 oder 2, dadurch gekennzeichnet, daß das Druckfundament (1) auf einer Platte (4) gelagert ist, die mittels gelenkiger Parallelogramme (2, 3, 5, 5a) um eine Achse (9) schwenken kann.

4. Maschine nach Anspruch 3, dadurch gekennzeichnet, daß sich die Platte über ihre Schwenkachse (9) hinaus durch einen Hebelteil (13) verlängert, auf dem eines der Enden von Federn (12) befestigt ist, deren andere Enden an einem Sockel (S) befestigt sind, und daß die Platte (4) darüberhinaus in der Umgebung ihres Mittelpunkts auf einem Stellzylinder (11) zur Steuerung des Schwenkens der Platte um die Schwenkachse (9) aufliegt.

5. Maschine nach einem der Ansprüche 3 bis 4, dadurch gekennzeichnet, daß die gelenkigen Parallelogramme aus Schwingarmen (2, 3) bestehen, die an ihren Enden an Lagerköpfen (5, 5a) angelenkt sind, die jeweils an dem Druckfundament (1) und der Platte (4) befestigt sind.

6. Maschine nach einem der Ansprüche 3 bis 5, dadurch gekennzeichnet, daß die Bewegung des Druckfundaments (1) im Hinblick auf die Abwärtsbewegung durch an der Platte (4) befestigte Anschläge (6) und durch einen mit einer Auflage (8) einstückigen nachgiebigen Anschlag (7) mit relativ großer Oberfläche für die genaue Positionierung in der oberen Stellung des Druckfundaments (1) als Reaktion auf die Betätigung des Steuerungsstellzylinders (V) begrenzt ist.

7. Maschine nach einem der vorhergehenden Ansprüche, dadurch gekennzeichnet, daß die Steuerungsvorrichtung ein Stellzylinder (41) mit doppelter Wirkung ist, dessen Stange (41a) an der Backe (40) mittels eines Kopfes (43) mit einstellbarer Position bezüglich der Stange des Stellzylinders angekoppelt ist.

8. Maschine nach einem der vorhergehenden Ansprüche, dadurch gekennzeichnet, daß jede Zange (15) einen biegsamen Haarnadel-Draht (49) aufweist, dessen oberes Ende in einem Einschnitt (42d) eines Schwingarms (42) aufliegt, dessen Mittelpunkt unter einer Achse (42c) des Schwingarms (42) gehalten wird, und dessen anderes Ende in einem Ständer (44) aufliegt, der auch den ebenfalls an der Backe (40) angelenkten Schwingarm (42) trägt.

9. Maschine nach Anspruch 8, dadurch gekennzeichnet, daß die Ständer (44) der Vielzahl einzelner Zangen (15) an demselben Winkelprofil (16) befestigt sind, das um die Schwenkachse (17) der Zangen (15) schwenken kann.

10. Druckmaschine nach einem der vorhergehenden Ansprüche, dadurch gekennzeichnet, daß sie einen Stellzylinder (20) zum Verschieben der Zangen zwischen einerseits einer hinteren Stellung und andererseits einer vorderen Stellung aufweist, in welcher die Zangen (15) in den Einschnitten (14) der ersten Auflage (1) sitzen.
